Europäisches Patentamt

European Patent Office

Office européen des brevets

(11) Numéro de publication: **0 269 505 B1**

(19)

(12) **FASCICULE DE BREVET EUROPEEN**

(45) Date de publication de fascicule du brevet: **12.08.92**  (51) Int. Cl.⁵: **H01R  9/09**

(21) Numéro de dépôt: **87402523.2**

(22) Date de dépôt: **09.11.87**

(54) **Procede de realisation d'un connecteur modulaire.**

(30) Priorité: **12.11.86 FR 8615970**

(43) Date de publication de la demande:
**01.06.88 Bulletin  88/22**

(45) Mention de la délivrance du brevet:
**12.08.92 Bulletin  92/33**

(84) Etats contractants désignés:
**BE DE ES FR GB IT NL SE**

(56) Documents cités:
**FR-A- 2 258 716**
**US-A- 4 645 287**

(73) Titulaire: **CETRA S.A.R.L.**
**Z.I. La Croix Blanche Ouest, 26, rue de la**
**Résistance**
**F-91700 Ste Geneviève-des-Bois(FR)**

(72) Inventeur: **Martin, Jean-Paul**
**74, rue Pasteur**
**F-91000 St Pierre-du-Perray(FR)**
Inventeur: **Kolozsvari, Guy**
**20, Chemin des Préharts**
**F-91370 Verrieres-Le-Buisson(FR)**

(74) Mandataire: **Boivin, Claude**
**9, rue Edouard-Charton**
**F-78000 Versailles(FR)**

## Description

Jusqu'à une époque récente, l'interconnexion des cartes à circuits imprimés était assurée par des connecteurs à n contacts dits "picots à souder". Ce procédé nécessitait de prévoir des pastilles de soudure sur les pistes de connexion et des perçages dans la carte au droit des pastilles, ce qui augmentait notablement le prix de revient de la carte. Les problèmes posés par cette connexion ont été aggravés par la venue sur le marché de composants montés en surface ou composants C.M.S. qui sont miniatures et nécessitent l'utilisation de cartes, de pistes et de connecteurs également miniaturisés.

Le document US-A- 4,645,287 décrit un connecteur dont les extrémités repliées sont soudées sur un circuit imprimé. Mais pour assurer le maintien des connecteurs en position correcte sur le circuit imprimé, il est nécessaire de prévoir des agrafes ou cavaliers dont les extrémités viennent s'encliqueter dans des trous prévus dans le circuit imprimé. Ces cavaliers doivent être posés à la main ou par une machine spéciale autre que celle ayant posé le connecteur sur le circuit imprimé.

La présente invention a pour objet un procédé de réalisation d'un connecteur qui évite ces inconvénients.

Ce procédé est caracterisé en ce qu'on utilise des modules dont l'embase est traversée par des éléments de connexion ayant une de leurs extrémités repliées sous l'embase, ces modules sont de deux types dont les dimensions sont analogues à celles d'un composant monté en surface et dont les faces latérales sont, pour les deux types, pentées sur la plus grande partie de leur hauteur, les modules du premier type ayant les parties repliées de leurs éléments de connexion situées du côté de la partie la plus large de l'embase alors que les modules du second type ont les parties repliées de leurs éléments de connexion situées du côté de la partie la moins large de l'embase, qu'on pose les modules de l'un des types sur un circuit imprimé, qu'on intercale ensuite entre eux les modules de l'autre type, et qu'on assure la fixation de l'ensemble des modules sur le circuit imprimé pour brasage des extrémités repliées des éléments de connexion sur des pistes du circuit imprimé.

On a décrit ci-après, à titre d'exemple non limitatif, un mode de mise en oeuvre du procédé selon l'invention, avec référence au dessin annexé dans lequel :

La Figure 1 est une vue en perspective du connecteur brasé sur une carte à circuit imprimé;

La Figure 2 en est une vue latérale;

La Figure 3 est une vue en perspective montrant la prise d'un module;

La Figure 4 est une vue en perspective d'une variante de module.

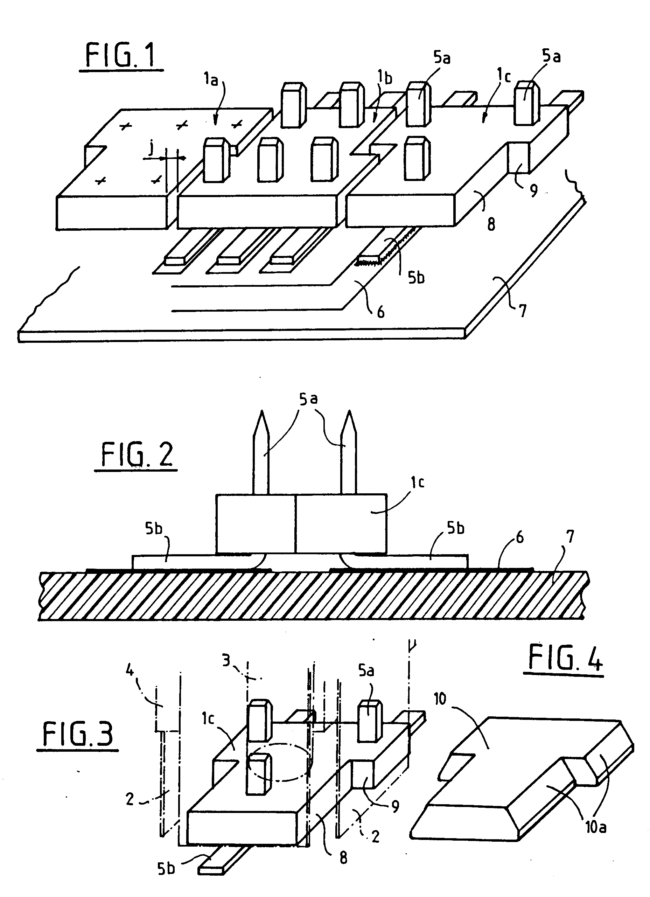

Tel qu'il est représenté au dessin, le connecteur selon l'invention est formé de deux ou plusieurs modules juxtaposés, au nombre de trois au dessin, comportant chacun une embase 1a, 1b ou 1c dont les dimensions sont analogues à celles des composants électroniques montés en surface de sorte qu'ils peuvent être saisis et posés par la même machine, comme le montre la Figure 3 où l'on voit des doigts de centrage 2 et une buse 3 portés par la tête 4 de la machine, la buse venant s'appliquer au centre de l'embase.

L'embase de chacun de ces modules est traversée par un certain nombre d'éléments de connexion. L'une 5a des extrémités de chacun de ces éléments s'étend vers le haut, perpendiculairement au plan de l'embase, et forme une broche de connexion, mâle ou femelle; l'autre extrémité 5b est repliée sous l'embase et peut ainsi être brasée sur une piste 6 d'un circuit imprimé 7. Ces éléments de connexion sont disposés en deux rangées ou plus, en quinconce, au pas désiré.

Les divers modules sont écartés les uns des autres d'un jeu j déterminé en fonction du pas des éléments de connexion et compatible avec la précision de pose des machines et de la capacité de compensation des contacts du réceptacle ou de la fiche coopérant avec le connecteur.

Les bords latéraux de chaque embase comportent chacun un décrochement 8 déterminant un épaulement 9.

Dans le mode de réalisation de la Figure 4 le module comporte une embase 10 dont les faces latérales telles que 10a sont pentées sur la plus grande partie de leur hauteur, l'embase étant ainsi partiellement en tronc de pyramide. Au dessin, la partie la plus large de l'embase est située du côté des parties repliées 5b des pattes de connexion; ce type de module s'utilise conjointement avec des modules ayant une forme similaire mais dont la partie la moins large de l'embase est située du côté des parties repliées 5b. Lors de la réalisation du connecteur, on pose d'abord les modules du premier type et on intercale ensuite entre eux ceux du second type, ce qui rattrappe la plus grande partie du jeu.

## Revendications

1. Procédé de réalisation d'un connecteur à l'aide de modules caractérisé en ce qu'on utilise des modules dont l'embase (10) a des dimensions analogues à celles d'un composant monté en surface et est traversée par des éléments de connexion ayant une (5b) de leurs extrémités repliée sous l'embase,

desdits modules sont de deux types dont les faces latérales (10a) sont, pour les deux types, pentées sur la plus grande partie de leur hauteur, les modules du premier type ayant les parties repliées (5b) de leurs éléments de connexion situées du côté de la partie la plus large de l'embase (10) alors que les modules du second type ont les parties repliées de leurs éléments de connexion situées du côté de la partie la moins large de l'embase, qu'on pose les modules de l'un des types sur un circuit imprimé (7), qu'on intercale ensuite entre eux les modules de l'autre type, et qu'on assure la fixation de l'ensemble des modules sur le circuit imprimé pour brasage des extrémités repliées (5b) des éléments de connexion sur des pistes (6) du circuit imprimé (7).

2. Procédé selon la revendication 1,
caractérisé en ce qu'on utilise des modules présentant une embase dont les bords latéraux comportent un décrochement.

**Claims**

1. Method for embodying a connector with the aid of modules, wherein modules are used whose seat (10) has dimensions similar to those of a surface-mounted component and is traversed by connection elements having one (5b) of their extremities being folded back under the seat, said modules being of two types whose lateral faces (10a) are for both types slanted over most of their height, the modules of the first type having the folded back portions (5b) of their connection elements situated on the side of the widest portion of the seat (10), whereas the modules of the second type have the folded back portions of their connection elements folded back situated on the side of the thinnest portion of the seat, wherein the modules of one of the types are laid on a printed circuit (7), wherein the modules of the other type are then inserted between them, and wherein all the modules are secured to the printed circuit for soldering the folded back extremities of the connection elements on the tracks (6) of the printed circuit (7).

2. Method according to claim 1,
wherein modules are used having one seat whose lateral edges comprise one horizontal flexure.

**Patentansprüche**

1. Verfahren zur Herstellung eines Verbinders mit Hilfe von Modulen, dadurch gekennzeichnet, daß der Sockel (10) dieser Module den Abmessungen einer Oberflächenkomponente entspricht und daß Verbindungskontakte durch ihn geführt werden, deren eines Ende (5b) auf der Sockelunterseite umgebogen ist, wobei die Module zweierlei Art sind, deren Seitenflächen (10a) bei beiden Arten über den größten Teil der Sockelhöhe abgeschrägt sind, wobei sich bei den Modulen der ersten Art der breitere Sockelteil (10) auf der Seite befindet, auf der die Verbinderkontakte umgebogen 5b sind, während sich bei den Modulen der zweiten Art der schmalere Sockelteil (10) auf der Seite befindet, auf der die Verbinderkontakte umgebogen 5b sind, daß zuerst die Module der ersten Art in entsprechenden Abständen auf einer Leiterplatte (7) angebracht und danach die Module der zweiten Art dazwischengesteckt werden und daß die Befestigung sämtlicher Module auf der Leiterplatte durch verlöten der umgebogenen Enden (5b) der Verbindungselemente mit den Leiterbahnen (6) der Leiterplatte (7) erfolgt.

2. Verfahren nach Patentanspruch 1, dadurch gekennzeichnet, daß Module verwendet werden, deren Sockel an den Seitenwänden einen Absatz bilden.

FIG. 1

FIG. 2

FIG. 3

FIG. 4